# EUROPEAN PATENT SPECIFICATION

(11) **EP 3 492 938 B1**
(45) Date of publication and mention of the grant of the patent: **01.09.2021**
(21) Application number: 16910466.8
(22) Date of filing: 26.07.2016
(51) Int. Cl.: G01R 31/34, G01R 31/00

(54) **ELECTRIC MOTOR DIAGNOSIS DEVICE**
ELEKTROMOTORDIAGNOSEVORRICHTUNG
DISPOSITIF DE DIAGNOSTIC DE MOTEUR ÉLECTRIQUE

(43) Date of publication of application: 05.06.2019
(73) Proprietor: Mitsubishi Electric Corporation, Chiyoda-ku Tokyo 100-8310 (JP)
(72) Inventor: MIYAUCHI Toshihiko, Tokyo 100-8310 (JP); KANEMARU Makoto, Tokyo 100-8310 (JP); MORI Mitsugi, Tokyo 100-8310 (JP); TSUKIMA Mitsuru, Tokyo 100-8310 (JP)
(74) Representative: Witte, Weller & Partner Patentanwälte mbB
(86) International application number: PCT/JP2016/071800
(87) International publication number: WO 2018/020563

(56) References cited:
- EP-A1- 1 298 511
- EP-A2- 1 489 475
- CN-B- 102 797 566
- JP-A- 2008 125 247
- JP-A- 2010 288 352
- JP-A- 2010 288 352
- JP-A- 2015 227 889
- JP-A- 2016 090 546
- JP-A- 2016 090 546
- US-A1- 2014 365 177
- US-A1- 2015 219 104
- US-B1- 7 308 322
- SAPENA-BANO A ET AL: "Support vector machine for diagnosis of inductioi motors: A comparative analysis in terms of the quantity and the signal processing tool used to build the feature space", 2013 9TH IEEE INTERNATIONAL SYMPOSIUM ON DIAGNOSTICS FOR ELECTRIC MACHINES, POWER ELECTRONICS AND DRIVES (SDEMPED), IEEE, 27 August 2013 (2013-08-27), pages 150-156, XP032514213, DOI: 10.1109/DEMPED.2013.6645710
- ANTONINO-DAVIU JOSE A ET AL: "Case stories of induction motors fault diagnosis based on current analysis", 2016 PETROLEUM AND CHEMICAL INDUSTRY CONFERENCE EUROPE (PCIC EUROPE), PCIC EUROPE, 14 June 2016 (2016-06-14), pages 1-9, XP032988034, DOI: 10.1109/PCICEUROPE.2016.7604635

## Description

### TECHNICAL FIELD

The present invention relates to an electric motor diagnosis device which is used at, for example, a control center such as a closed distribution board and which diagnoses whether or not there is an abnormality in an induction motor.

### BACKGROUND ART

Conventionally, an equipment abnormality diagnosis method has been proposed which measures load current of an induction motor and performs frequency analysis, and then, focusing on sidebands occurring on both sides of an operation frequency, diagnoses abnormality of the induction motor and a device driven by the induction motor, on the basis of disturbance of the waveform in the vertical direction in a short cycle and the state of undulation which is oscillation of the waveform in the vertical direction in a long cycle (for example, Patent Document 1).

Patent Document 2, according to its abstract, relates to a power meter or overload relay including a housing and a plurality of sensors configured to monitor operation of a motor. A processor is disposed within the housing and is configured to receive operational feedback from the plurality of sensor and proactively determine an operational wellness of the motor from the operational feedback.

Patent Document 3, according to its abstract, relates to facilitate detection of a fault in a facility ineluding a motor and equipment driven by the motor. At least either a load current or a zero-phase current of an induction motor that drives equipment is measured. Based on the result of analyzing frequency, both or either of the following is compared with a predetermined condition: at least one of the presence/absence, frequency, and magnitude of a side band that occurs both on the high-frequency and low-frequency sides of an operating frequency f<SB>L</SB>and at least one of disturbance and undulation of the waveform of the frequency analysis. Based on the result of the comparison, a fault is diagnosed in the facility including the induction motor 14, equipment 17, and coupling 16.

Patent Document 4, according to its abstract, relates to current diagnostic device 1 that includes: current measuring means for measuring load current of a motor; filtering means; frequency analysis means for subjecting a filtered current waveform to frequency analysis; first abnormality determining means for determining whether a rotation system error exists in a diagnosis target device; magnification calculating means; second abnormality determining means for determining whether a fluidic abnormality exists; spectrum level calculating means; third abnormality determining means for determining whether a bearing-derived abnormality exists; and diagnostic results outputting means for outputting the determination results,

Patent Document 5, according to its abstract, relates to systems and methods for controlling, diagnosing and prognosing the health of a motorized system. The systems may comprise a diagnostics system, a prognostic system and a controller, wherein the diagnostics system and/or prognostic system employs a neural network, an expert system, and/or a data fusion component in order to assess and/or prognose the health of the motorized system according to one or more attributes associated therewith. The controller may operate the motorized system in accordance with a setpoint and/or a diagnostics signal from the diagnostics system and/or prognostic information. Also disclosed are methodologies for controlling, diagnosing and prognosing the health of a motorized system, comprising operating a motor in the motorized system in a controlled fashion, diagnosing and/or prognosing the health of the motorized system according to a measured attribute associated with the motorized system, wherein the motor may be operated according to a setpoint and/or the diagnostics signal and/or prognosis.

### CITATION LIST

### PATENT DOCUMENT

Patent Document 1: Japanese Patent No. 4782218
Patent Document 2: EP 1 489 475 A2
Patent Document 3: JP 2010-288352 A
Patent Document 4: JP 2016-090546 A
Patent Document 5: EP 1 298 511 A1

### SUMMARY OF THE INVENTION

### PROBLEMS TO BE SOLVED BY THE INVENTION

In the conventional equipment abnormality diagnosis method, when load torque variation occurs in the induction motor, the spectrum intensities on both sides near the power supply frequency (operation frequency) increase and thus become greater than the oscillation intensity of sideband waves occurring in a peak form on both sides of the power supply frequency, leading to a problem that it is difficult to detect the sideband waves.

The present invention has been made to solve the above problem, and an object of the present invention is to provide an electric motor diagnosis device capable of, even for an electric motor having varying load torque, diagnosing whether or not there is an abnormality in the electric motor by detecting sideband waves occurring in a peak form on both sides near the power supply frequency.

### SOLUTION TO THE PROBLEMS

Therefore, there is provided an electric motor diagnosis device according to claim 1.

### EFFECT OF THE INVENTION

According to the present invention, the electric motor diagnosis device includes: a current input unit 10 for detecting and inputting current of an electric motor 5; an FFT analysis interval determination unit 13 which calculates a variation value of current variation data acquired in advance, on the basis of a standard deviation or a Mahalanobis distance, and which determines that a stable state is established, when a variation value of the current from the current input unit 10 is present within such a current interval as not to exceed a threshold value selected so as to enable detection of sideband waves in a power spectrum of the current; an FFT analysis unit 14 for analyzing a power spectrum of the current determined to be in the stable state by the FFT analysis interval determination unit 13; a peak detection calculation unit 15 for detecting a peak part in the power spectrum obtained by the FFT analysis unit 14; an averaging calculation unit 18 for averaging a plurality of the power spectra analyzed by the FFT analysis unit 14; a sideband wave extraction unit 19 for extracting sideband waves from the power spectrum averaged by the averaging calculation unit 18; and an alarm output unit 21 for outputting an alarm when sideband waves having signal intensities equal to or greater than a set value are extracted by the sideband wave extraction unit 19. Therefore, by the FFT analysis unit 14 analyzing a power spectrum when the current is in a stable state, it becomes possible to assuredly detect peak parts occurring on both sides of the power supply frequency. In addition, by the averaging calculation unit 18 averaging a plurality of power spectra, signal intensities of peak parts mixed into the power spectra owing to noise or the like are reduced, whereby the sideband wave extraction unit 19 can extract sideband waves more assuredly, thus providing an effect that it becomes possible to obtain an electric motor diagnosis device capable of, even for an electric motor 5 having varying load torque, diagnosing whether or not there is an abnormality in the electric motor 5 by detecting sideband waves occurring in a peak form on both sides near the power supply frequency.

### BRIEF DESCRIPTION OF THE DRAWINGS

[FIG. 1] FIG. 1 is a schematic configuration diagram showing an installation state of an electric motor diagnosis device according to embodiment 1 of the present invention.
[FIG. 2] FIG. 2 is a block diagram showing the configuration of a logical calculation unit of the electric motor diagnosis device according to embodiment 1 of the present invention.
[FIG. 3] FIG. 3 illustrates a frequency analysis result in the case where an electric motor has great load variation, in the electric motor diagnosis device according to embodiment 1 of the present invention.
[FIG. 4] FIG. 4 illustrates conversion of a frequency axis in the electric motor diagnosis device according to embodiment 1 of the present invention.
[FIG. 5] FIG. 5 is a flowchart illustrating operation of the electric motor diagnosis device according to embodiment 1 of the present invention.
[FIG. 6] FIG. 6 is a schematic configuration diagram showing an installation state of an electric motor diagnosis device according to embodiment 2 of the present invention.
[FIG. 7] FIG. 7 is a block diagram showing the configuration of a logical calculation unit in the electric motor diagnosis device according to embodiment 2 of the present invention.
[FIG. 8] FIG. 8 illustrates trend analysis of the electric motor diagnosis device according to embodiment 2 of the present invention.
[FIG. 9] FIG. 9 illustrates setting of a threshold value in the electric motor diagnosis device according to embodiment 1 of the present invention.

### DESCRIPTION OF EMBODIMENTS

Hereinafter, embodiments of the present invention will be described, while the same or corresponding parts are denoted by the same reference characters in the drawings.

### Embodiment 1

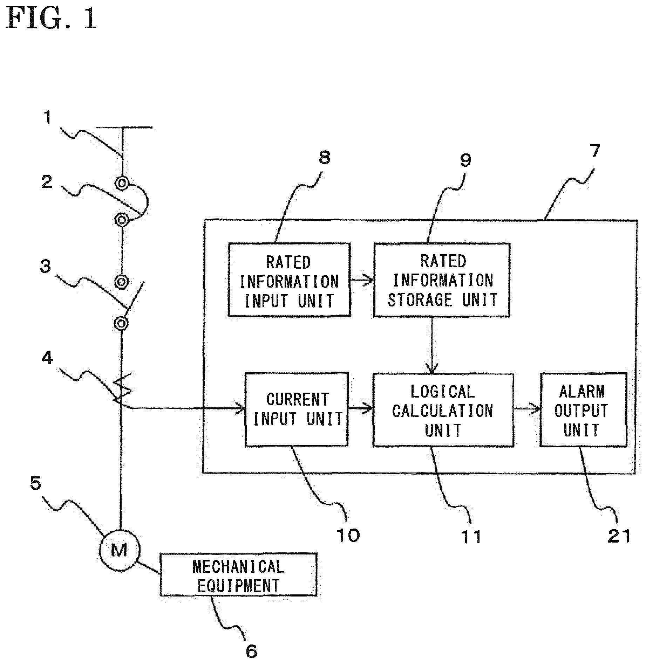

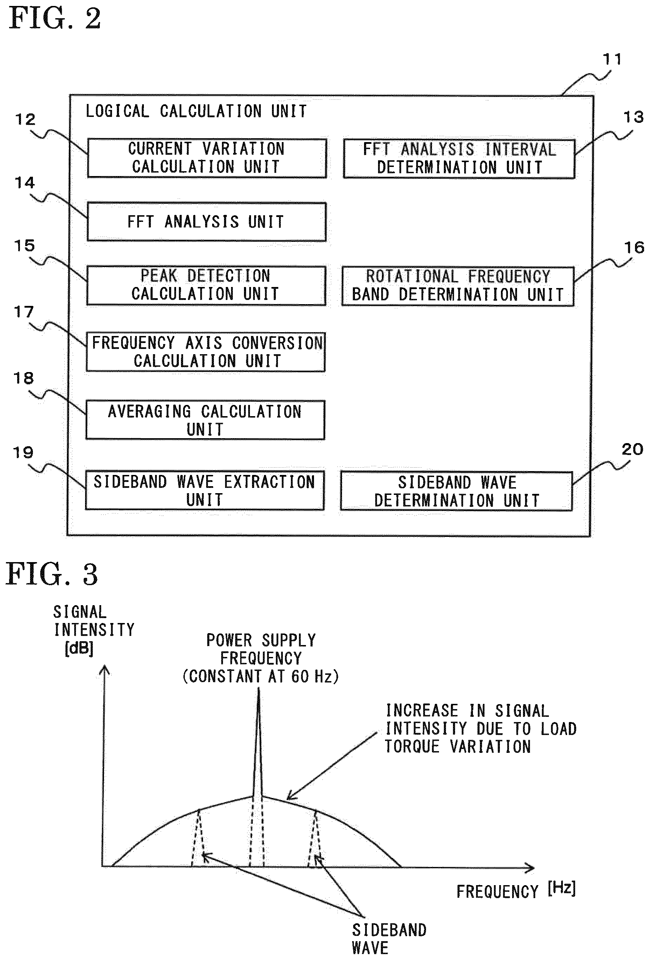

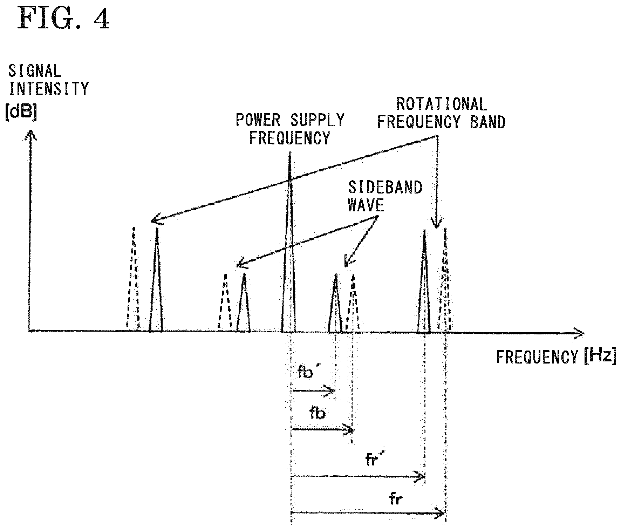

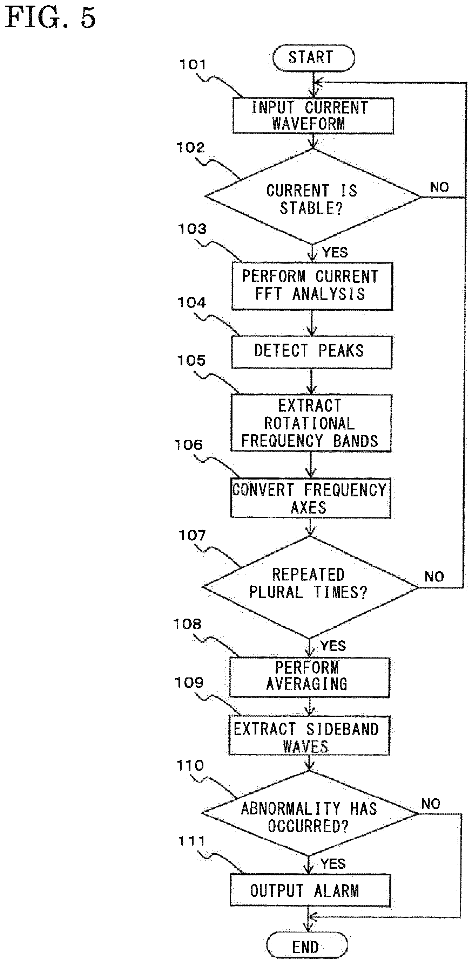

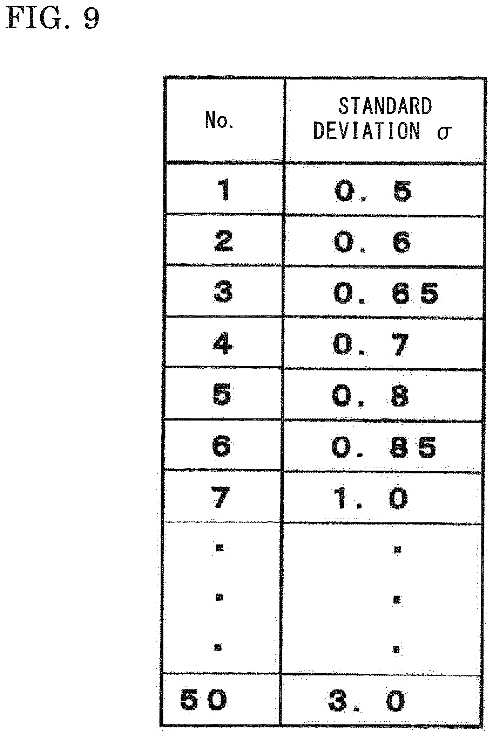

FIG. 1 is a schematic configuration diagram showing an installation state of an electric motor diagnosis device according to embodiment 1 of the present invention. FIG. 2 is a block diagram showing the configuration of a logical calculation unit of the electric motor diagnosis device according to embodiment 1 of the present invention. FIG. 3 illustrates a frequency analysis result in the case where an electric motor has great load variation in the electric motor diagnosis device according to embodiment 1 of the present invention. FIG. 4 illustrates conversion of a frequency axis in the electric motor diagnosis device according to embodiment 1 of the present invention. FIG. 5 is a flowchart illustrating operation of the electric motor diagnosis device according to embodiment 1 of the present invention. FIG. 9 illustrates setting of a threshold value in the electric motor diagnosis device according to embodiment 1 of the present invention.

In FIG. 1, a main circuit 1 led from a power grid is provided with: a wiring circuit breaker 2; an electromagnetic contactor 3; and a current detector 4 such as an instrument transformer for detecting load current for one phase of the three-phase main circuit 1. An electric motor 5 such as a three-phase induction motor which is a load is connected to the main circuit 1, and mechanical equipment 6 is operated and driven by the electric motor 5. An electric motor diagnosis device 7 includes: a rated information input unit 8 to which the power supply frequency, and the rated output, the rated voltage, the rated current, the number of poles, the rated rotation rate, etc., of the electric motor 5 are inputted in advance; and a rated information storage unit 9 which stores the rated information inputted from the rated information input unit 8. The rated information can be easily acquired by looking at a catalog of the manufacturer of the electric motor 5 or the rating plate attached to the electric motor 5. It is noted that, if there are a plurality of electric motors 5 as diagnosis targets, the rated information of all the electric motors 5 as diagnosis targets is inputted in advance, but in the following description, the case of one electric motor 5 will be described. In addition, the electric motor diagnosis device 7 includes: a current input unit 10 for inputting current detected by the current detector 4; a logical calculation unit 11 which diagnoses whether or not there is an abnormality in the electric motor 5, using the current inputted from the current input unit 10; and an alarm output unit 21 which outputs an alarm by means of alarming or lighting of an abnormality lamp when abnormality is found by the logical calculation unit 11.

The configuration of the logical calculation unit 11 will be described with reference to FIG. 2. The logical calculation unit 11 includes: a current variation calculation unit 12 which calculates whether or not there is variation in current inputted from the current input unit 10; an FFT analysis interval determination unit 13 which extracts an interval in which the current is stable, using the result calculated by the current variation calculation unit 12, and determines a power spectrum analysis interval; an FFT analysis unit 14 which performs power spectrum analysis using the current in the interval determined by the FFT analysis interval determination unit 13; a peak detection calculation unit 15 which detects peak parts included in the power spectrum analyzed by the FFT analysis unit 14; a rotational frequency band determination unit 16 which calculates a peak part attributed to a rotational frequency from the peak parts detected by the peak detection calculation unit 15; a frequency axis conversion calculation unit 17 which aligns the frequencies of rotational frequency bands in a plurality of power spectra; an averaging calculation unit 18 which performs averaging processing for the plurality of power spectra for which the frequency axes have been converted by the frequency axis conversion calculation unit 17; a sideband wave extraction unit 19 which extracts, if any, peak parts (hereinafter, these peak parts are referred to as sideband waves) other than the rotational frequency band, on both sides of the power supply frequency, using the power spectrum averaged by the averaging calculation unit 18; and a sideband wave determination unit 20 which determines whether or not the signal intensities of the sideband waves when the sideband waves are extracted by the sideband wave extraction unit 19 are equal to or greater than a set value.

The current variation calculation unit 12 calculates statistic variation in the current value on the basis of the current from the current input unit 10. The variation may be calculated by a method using standard deviation, Mahalanobis distance, or the like.

The FFT analysis interval determination unit 13 determines a power spectrum analysis interval by extracting only a current interval in which variation is a threshold value or less and thus the current value is stable, from the statistic variation in the current value calculated by the current variation calculation unit 12. In general, if load torque of the electric motor 5 varies, variation occurs in the current value, and then if power spectrum analysis is performed on the current waveform having great variation, as shown in FIG. 3, the signal intensities on both sides near the power supply frequency increase and thus peak parts such as sideband waves do not appear. In order to prevent this, the threshold value of the FFT analysis interval determination unit 13 is provided.

The FFT analysis unit 14 performs frequency analysis using a current waveform inputted in the interval determined by the FFT analysis interval determination unit 13, thereby calculating a current power spectrum intensity. Since the power spectrum analysis is performed on the current waveform in which the current value is stable, the power spectrum intensities on both sides near the power supply frequency do not increase, and therefore, if peak parts exist, the peak parts assuredly appear.

From a result of analysis of the current power spectrum intensity, the peak detection calculation unit 15 detects a peak part due to a power supply frequency, peak parts due to rotational frequencies, peak parts due to sideband waves, and other peak parts. Such peak parts can be detected by extracting a part where a sharp slope is inverted in a calculation result of first-order, second-order, and third-order differential calculations. By performing differential calculations up to third order, it becomes possible to detect peak parts having smaller signal intensities. A peak part due to the power supply frequency arises at the position of the power supply frequency (in general, 50 Hz or 60 Hz) stored in the rated information storage unit 9, and therefore this peak part can be easily confirmed.

The rotational frequency band determination unit 16 calculates a rotational frequency from the rated rotation rate stored in the rated information storage unit 9, and extracts peak parts that have the same signal intensity and are located near positions shifted toward both sides from the power supply frequency as a center by an amount corresponding to the rotational frequency. In general, the electric motor 5 causes slip in accordance with the condition of load torque and thus shift occurs in the rotation rate. Therefore, peak parts attributed to the rotational frequency also appear so as to be shifted accordingly. The rotational frequency band determination unit 16 extracts peak parts present in frequency bands for which the shift is considered, thereby determining rotational frequency bands.

The frequency axis conversion calculation unit 17 is needed for the averaging calculation unit 18 to correctly perform averaging calculation. In general, the occurrence position of a sideband wave occurring due to abnormality of the electric motor 5 is deeply related to a rotational frequency band, and the frequency band of the sideband wave is often a multiple of the rotational frequency band. In addition, as described above, the rotational frequency band appears so as to be shifted in accordance with the condition of load torque of the electric motor 5. Therefore, the frequency axes of a plurality of power spectrum analysis results to be averaged need to be aligned by a peak part follow-up method. Specifically, as shown in FIG. 4, it is assumed that the frequency of a rotational frequency band is at a position separated by fr from the power supply frequency, the frequency of a sideband is at a position separated by fb from the power supply frequency, and the frequency of a rotational frequency band when the electric motor 5 is under no load is at a position separated by fr' from the power supply frequency. In this case, a conversion ratio α is represented as α = fr'/fr, and a position fb' of a sideband wave in the case of no load can be calculated as fb' = α-fb. In this way, the conversion ratio α is multiplied using the rotational frequency band as a reference, whereby the frequency axes of all peak parts are converted. In the above description, the case where the frequency axes are aligned with that in the case of no load has been described. However, the frequency axis conversion calculation unit 17 may be configured such that the frequency axes in a plurality of power spectrum analysis results to be averaged are aligned with that in the case of given load, e.g., the frequency axes may be aligned with that in the case of rated load.

The averaging calculation unit 18 performs averaging processing on a plurality of power spectrum analysis results for which the frequency axes have been aligned by the frequency axis conversion calculation unit 17. By performing the averaging processing, basis noise is reduced, whereby the S/N ratio for peak parts can be improved. Specifically, if ten power spectrum analysis results are subjected to averaging processing, the signal intensity of a peak part due to noise or the like that has occurred in only one of the power spectrum analysis results is reduced to 1/10. On the other hand, as for the rotational frequency bands and the sideband waves, peak parts arise in all the ten power spectrum analysis results, and the frequency axes thereof are converted by a peak follow-up method so that the frequencies are aligned. Therefore, the signal intensities of these peak parts do not change even if the averaging processing is performed. In the above description, the case of averaging ten power spectrum analysis results has been described. However, without limitation to ten, a plurality of power spectrum analysis results may be averaged.

From the power spectrum analysis result averaged by the averaging calculation unit 18, the sideband wave extraction unit 19 extracts, as sideband waves, peak parts arising at positions shifted by an equal frequency toward both sides from the power supply frequency as a center. Peak parts as candidates for sideband waves are selected from the peak parts obtained by the peak detection calculation unit 15. If a peak part arises on only one side with respect to the power supply frequency as a center, the peak part is determined to be not a sideband wave and thus is not extracted.

The sideband wave determination unit 20 determines whether or not the electric motor 5 is abnormal, on the basis of the number and the signal intensities of the sideband waves extracted by the sideband wave extraction unit 19. If the electric motor 5 is determined to be abnormal, an alarm is outputted from the alarm output unit 21.

Next, operation will be described with reference to FIG. 5. The electric motor diagnosis device 7 is started at predetermined time intervals and executes the following process. In step 101, current of the electric motor 5 detected by the current detector 4 is inputted through the current input unit 10. In step 102, the current variation calculation unit 12 calculates variation in the effective value (hereinafter, referred to as current value) of the current inputted from the current input unit 10, and using a result of the calculation, the FFT analysis interval determination unit 13 determines whether or not the current is in a stable state. As a determination result, if the current is in an unstable state in which the variation in the current value is equal to or greater than a predetermined threshold value (NO), the process returns to step 101 and is repeated until the current comes into a stable state. If the current is in a stable state (YES), the process proceeds to step 103. Regarding the threshold value, for example, field data for a plurality of motors are acquired in advance, and then, from the current variation values (standard deviations) in the data, a value is selected within a range in which the variation values are small, whereby the selected value is used as the threshold value. As a specific calculation example, as shown in FIG. 9, fifty variation values are calculated and are rearranged in ascending order. Then, among the rearranged values, the fifth smallest variation value, i.e., 0.8 is determined as the threshold value. Instead of obtaining the field data in advance, a certain learning period may be set for the electric motor 5, and the same calculation may be performed from the current variation values (standard deviations) acquired during the learning period.

In step 103, using the current waveform in an interval in which the inputted current value is in a stable state, the FFT analysis unit 14 performs frequency analysis in a range between 0 Hz and 120 Hz which is twice as high as the power supply frequency 60 Hz, and sends the power spectrum analysis result to the peak detection calculation unit 15. In step 104, the peak detection calculation unit 15 detects all the peak parts included in the power spectrum analysis result. In step 105, the rotational frequency band determination unit 16 extracts peak parts present in rotational frequency bands from among the detected peak parts, thereby determining rotational frequency bands. In step 106, the frequency axis conversion calculation unit 17 converts the frequency axes of all the peak parts so that the detected rotational frequency bands become a rotational frequency band in the case of no load. In step 107, the operations of steps 101 to 106 are repeated ten times, thereby collecting ten power spectrum analysis results in which the frequency axes have been converted.

In step 108, the averaging calculation unit 18 performs averaging processing for the collected ten power spectrum analysis results. In step 109, the sideband wave extraction unit 19 extracts sideband waves, focusing on peak parts in the averaged power spectrum analysis result. In step 110, if no sideband waves are extracted by the sideband wave extraction unit 19 or if sideband waves are extracted but have signal intensities smaller than a set value, the sideband wave determination unit 20 determines that abnormality has not occurred in the electric motor 5 (NO), and thus the diagnosis process is ended. On the other hand, if the signal intensities of the sideband waves extracted by the sideband wave extraction unit 19 are greater than the set value (YES), the sideband wave determination unit 20 determines that abnormality has occurred in the electric motor 5, and outputs a signal to the alarm output unit 21 accordingly. Then, in step 111, the alarm output unit 21 outputs an alarm and thus the diagnosis process is ended. It is noted that, regarding the set value for the sideband wave determination unit 20, a signal intensity A of sideband waves in a normal case is learned and a standard deviation σ is calculated, and then a range in which there are 99.7% of data in which the detected sideband wave peak values are A+3o, is used as the set value. Alternatively, A+3σ×α obtained by multiplying a safety coefficient α (for example, 2 or greater) may be used. As another method for determining the above set value, the set value may be determined from data or the like for past failures of the same type of electric motors, and thus, as the number of failure cases increases, it becomes possible to determine the failure location and the failure degree more accurately on the basis of the sideband waves.

As described above, the current waveform when the current value is stable is subjected to power spectrum analysis, whereby peak parts such as sideband waves appear assuredly. In addition, by performing averaging processing, noise and the like are reduced and thus more accurate failure diagnosis can be performed.

### Embodiment 2

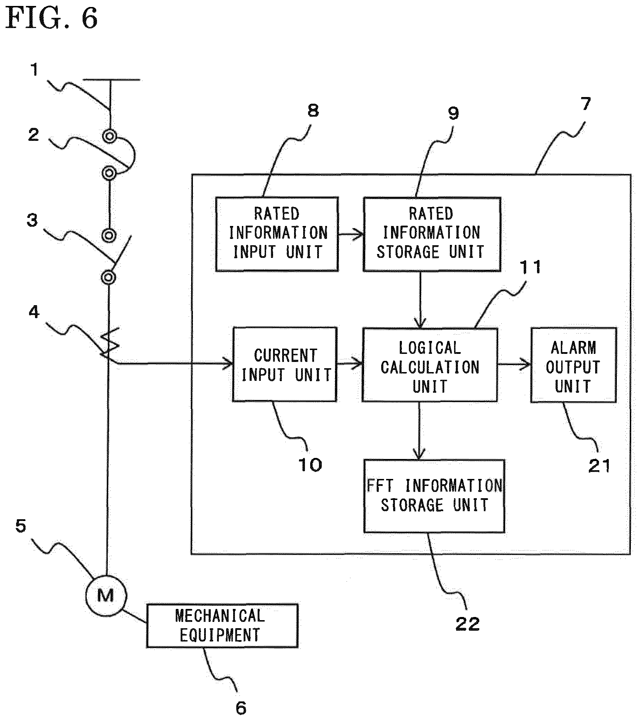

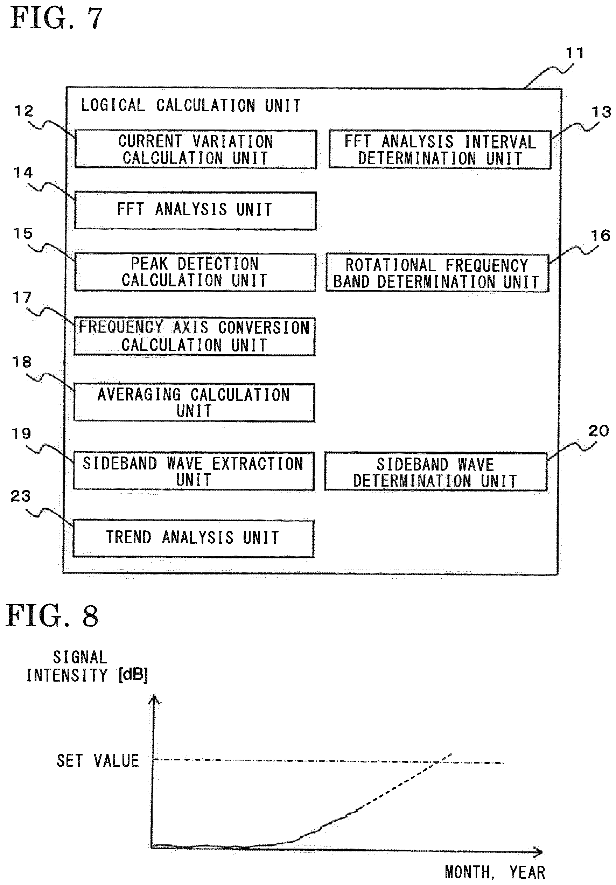

FIG. 6 is a schematic configuration diagram showing an installation state of an electric motor diagnosis device according to embodiment 2 of the present invention. FIG. 7 is a block diagram showing the configuration in a logical calculation unit of the electric motor diagnosis device according to embodiment 2 of the present invention. FIG. 8 illustrates trend analysis of the electric motor diagnosis device according to embodiment 2 of the present invention. In the above embodiment 1, the case of diagnosing abnormality of the electric motor 5 using an averaged power spectrum analysis result has been described. However, in embodiment 2, the case where averaged power spectrum analysis results are stored in time series and trend monitoring is performed, will be described.

In FIG. 6, the electric motor diagnosis device 7 includes an FFT information storage unit 22 which stores averaged power spectrum analysis results in time series, and as shown in FIG. 7, the logical calculation unit 11 includes a trend analysis unit 23.

Next, operation of the trend analysis unit 23 will be described. Focusing on sideband waves having a specific frequency in the power spectrum analysis results stored in time series in the FFT information storage unit 22, the trend analysis unit 23 calculates the signal intensities of the sideband waves in time series as shown in FIG. 8, and indicates the signal intensities. A set value in FIG. 8 is the set value used in the sideband wave determination unit 20. By performing the trend analysis as described above, the following effect is obtained. For example, in the case where sideband waves arise due to wearing of a bearing of the electric motor 5, if the signal intensities of the sideband waves are small, the degree of the wearing of the bearing is small and thus it is not determined that abnormality occurs, but since the wearing of the bearing gradually increases, the signal intensities of the sideband waves also gradually increase in time series as shown in FIG. 8. Therefore, the time at which the signal intensities of the sideband waves reach the set value and the bearing needs to be exchanged can be found through execution of the trend analysis. The other parts are the same as in embodiment 1 and therefore the description thereof is omitted.

It is noted that, within the scope of the present invention, the above embodiments may be freely combined with each other, or each of the above embodiments may be modified or simplified as appropriate.

### DESCRIPTION OF THE REFERENCE CHARACTERS

- 1: main circuit
- 2: wiring circuit breaker
- 3: electromagnetic contactor
- 4: current detector
- 5: electric motor
- 6: mechanical equipment
- 7: electric motor diagnosis device
- 8: rated information input unit
- 9: rated information storage unit
- 10: current input unit
- 11: logical calculation unit
- 12: current variation calculation unit
- 13: FFT analysis interval determination unit
- 14: FFT analysis unit
- 15: peak detection calculation unit
- 16: rotational frequency band determination unit
- 17: frequency axis conversion calculation unit
- 18: averaging calculation unit
- 19: sideband wave extraction unit
- 20: sideband wave determination unit
- 21: alarm output unit
- 22: FFT information storage unit
- 23: trend analysis unit

## Claims

1. An electric motor diagnosis device comprising:
a current input unit (10) for detecting and inputting current of an electric motor (5);
an FFT analysis interval determination unit (13) which is configured to calculate a variation value of current variation data acquired in advance, on the basis of a standard deviation or a Mahalanobis distance, and to determine that a stable state is established, when a variation value of the current from the current input unit (10) is present within such a current interval as not to exceed a threshold value selected so as to enable detection of sideband waves in a power spectrum of the current;
an FFT analysis unit (14) for analyzing a power spectrum of the current determined to be in the stable state by the FFT analysis interval determination unit (13);
a peak detection calculation unit (15) for detecting a peak part in the power spectrum obtained by the FFT analysis unit (14);
an averaging calculation unit (18) for averaging a plurality of the power spectra analyzed by the FFT analysis unit (14);
a sideband wave extraction unit (19) for extracting sideband waves from the power spectrum averaged by the averaging calculation unit (18); and
an alarm output unit (21) for outputting an alarm when sideband waves having signal intensities equal to or greater than a set value are extracted by the sideband wave extraction unit (19),
wherein the averaging calculation unit (18) is configured to perform the averaging in a state in which frequency axes of the plurality of the power spectra have been converted so as to align peak parts due to rotational frequency bands.

2. The electric motor diagnosis device according to claim 1, wherein
the electric motor diagnosis device is configured to store information about the power spectrum averaged by the averaging calculation unit (18) and to subject sideband waves to trend monitoring.

## Patentansprüche

1. Elektromotordiagnoseeinrichtung, mit:
einer Stromeingabeeinheit (10) zum Detektieren und Eingeben eines Stroms eines Elektromotors (5);
einer FFT-Analyseintervallbestimmungseinheit (13), die dazu konfiguriert ist, einen Variationswert von Stromvariationsdaten, die vorab erlangt sind, zu berechnen, auf der Basis einer Standardabweichung oder einer Mahalanobis-Entfernung, und zu bestimmen, dass ein stabiler Zustand erreicht ist, wenn ein Variationswert des Stroms von der Stromeingabeeinheit (10) innerhalb solch eines Stromintervalls vorhanden ist, dass er nicht einen Schwellwert überschreitet, der so ausgewählt ist, dass eine Detektion von Seitenbandwellen in einem Leistungsspektrum des Stroms ermöglicht ist;
einer FFT-Analyseeinheit (14) zum Analysieren eines Leistungsspektrums des Stroms, der durch die FFT-Analyseintervallbestimmungseinheit (13) dazu bestimmt ist, in dem stabilen Zustand zu sein;
einer Spitzendetektionsberechnungseinheit (15) zum Detektieren eines Spitzenteils im Leistungsspektrum, das durch die FFT-Analyseeinheit (14) erlangt ist;
einer Durchschnittsberechnungseinheit (18) zum Mitteln einer Mehrzahl von den Leistungsspektra, die durch die FFT-Analyseeinheit (14) analysiert sind;
einer Seitenbandwellenextraktionseinheit (19) zum Extrahieren von Seitenbandwellen von dem Leistungsspektrum, das durch die Durchschnittsberechnungseinheit (18) gemittelt ist; und
einer Alarmausgabeeinheit (21) zum Ausgeben eines Alarms, wenn Seitenbandwellen, die Signalintensitäten gleich zu oder größer als ein festgesetzter Wert aufweisen, durch die Seitenbandwellenextraktionseinheit (19) extrahiert sind,
wobei die Durchschnittsberechnungseinheit (18) dazu konfiguriert ist, das Mitteln in einem Zustand durchzuführen, in dem Frequenzachsen der Mehrzahl von den Leistungsspektra konvertiert worden sind, um Spitzenteile aufgrund von Rotationsfrequenzbändern auszurichten.

2. Elektromotordiagnoseeinrichtung nach Anspruch 1, wobei:
die Elektromotordiagnoseeinrichtung dazu konfiguriert ist, Information über das Leistungsspektrum, das durch die Durchschnittsberechnungseinheit (18) gemittelt ist, zu speichern und Seitenbandwellen einer Trendüberwachung zu unterziehen.

## Revendications

1. Dispositif de diagnostic de moteur électrique comprenant :
une unité d'entrée de courant (10) pour détecter et entrer le courant d'un moteur électrique (5) ;
une unité de détermination d'intervalle d'analyse FFT (13) qui est configurée pour calculer une valeur de variation de données de variation de courant acquises à l'avance, sur la base d'un écart type ou d'une distance de Mahalanobis, et pour déterminer qu'un état stable est établi, lorsqu'une valeur de variation du courant provenant de l'unité d'entrée de courant (10) est présente dans un intervalle de courant de manière telle qu'il ne dépasse pas une valeur de seuil sélectionnée, de manière à permettre la détection d'ondes de bande latérale dans un spectre de puissance du courant ;
une unité d'analyse FFT (14) pour analyser un spectre de puissance du courant déterminé comme étant dans l'état stable par l'unité de détermination d'intervalle d'analyse FFT (13) ;
une unité de calcul de détection de pic (15) pour détecter une partie de pic dans le spectre de puissance obtenu par l'unité d'analyse FFT (14) ;
une unité de calcul de moyenne (18) pour calculer la moyenne d'une pluralité de spectres de puissance analysés par l'unité d'analyse FFT (14) ;
une unité d'extraction d'ondes de bande latérale (19) pour extraire des ondes de bande latérale du spectre de puissance dont la moyenne est calculée par l'unité de calcul de moyenne (18) ; et
une unité de sortie d'alarme (21) pour délivrer une alarme lorsque des ondes de bande latérale ayant des intensités de signal égales ou supérieures à une valeur fixée sont extraites par l'unité d'extraction d'ondes de bande latérale (19),
où l'unité de calcul de moyenne (18) est configurée pour effectuer le calcul de moyenne dans un état dans lequel les axes de fréquence de la pluralité des spectres de puissance ont été convertis de manière à aligner les parties de pic dues aux bandes de fréquence de rotation.

2. Dispositif de diagnostic de moteur électrique selon la revendication 1, dans lequel :
le dispositif de diagnostic de moteur électrique est configuré pour stocker des informations sur le spectre de puissance dont la moyenne est calculée par l'unité de calcul de moyenne (18) et pour soumettre les ondes de bande latérale à une surveillance de tendance.
